# EUROPÄISCHE PATENTSCHRIFT

(11) **EP 0 342 444 B1**
(45) Veröffentlichungstag und Bekanntmachung des Hinweises auf die Patenterteilung: **18.11.1993**
(21) Anmeldenummer: 89108090.5
(22) Anmeldetag: 05.05.1989
(51) Int. Cl.: C07F 5/06, C07F 5/00, C30B 25/02, C30B 29/40, C23C 16/30

(54) **Cyclische metallorganische Verbindungen**
Cyclical organic-metal compounds
Composés métallorganiques cycliques

(30) Priorität: 19.05.1988 DE 3817090
(43) Veröffentlichungstag der Anmeldung: 23.11.1989
(73) Patentinhaber: MERCK PATENT GmbH, D-64271 Darmstadt (DE)
(72) Erfinder: Erdmann, Dietrich, Dr., D-6109 Mühltal-Traisa (DE); Pohl, Ludwig, Dr., D-6100 Darmstadt (DE); Hostalek, Martin, Dr., D-6100 Darmstadt (DE); Lokai, Matthias, D-6100 Darmstadt (DE)

(56) Entgegenhaltungen:
- EP-A- 0 260 534
- THIN SOLID FILMS, Band 174, 1989, GB; M. HOSTALEK et al., Seiten 1-4*
- MATERIALS RESEARCH SOCIETY SYMPOSIA PROCEEDINGS, Band 145(III-V Heterostruct. Electron./Photonic Devices), 1989, GB; M. HOSTALEK etal., Seiten 205-210*

## Beschreibung

Die Erfindung betrifft cyclische metallorganische Verbindungen, die Aluminium, Gallium oder Indium als Metalle enthalten sowie die Verwendung dieser Verbindungen für die Herstellung dünner Filme oder epitaktischer Schichten durch Gasphasenabscheidung.

Die Abscheidung solcher Schichten aus entweder reinen Elementen der III. Gruppe oder aus Kombinationen mit anderen Elementen, wie z.B. Galliumarsenid, Indiumphosphid oder Galliumphosphid, kann zur Herstellung von elektronischen und optoelektronischen Schaltelementen, Verbindungshalbleitern und Lasern verwendet werden. Die Abscheidung dieser Schichten erfolgt aus der Gasphase.

Die Eigenschaften dieser Filme hängen von den Abscheidungsbedingungen und der chemischen Zusammensetzung des abgeschiedenen Films ab.

Für die Abscheidung aus der Gasphase kommen alle bekannten Methoden wie die Metal-Organic Chemical Vapour Deposition (MOCVD) Methode, die Photo-Metal-Organic Vapour Phase (Photo-MOVP) Methode, bei welcher die Substanzen durch UV-Bestrahlung zersetzt werden, die Laser Chemical Vapour Deposition (Laser CVD) Methode oder die Metal-Organic Magnetron Sputtering (MOMS) Methode in Frage. Die Vorteile gegenüber anderen Methoden sind ein kontrollierbares Schichtenwachstum, eine genaue Dotierungskontrolle sowie eine aufgrund der Normal- oder Niederdruckbedingungen einfache Handhabung und Produktionsfreundlichkeit.

Bei der MOCVD-Methode werden metallorganische Verbindungen eingesetzt, die sich unter Abscheidung des Metalls bei einer Temperatur unterhalb 1100 °C zersetzen. Typische Apparaturen, die zur Zeit für MOCVD benutzt werden, bestehen aus einem "bubbler" mit einer Zufuhr für die metallorganische Komponente, einer Reaktionskammer, die das zu beschichtende Substrat enthält, sowie einer Quelle für ein Trägergas, das gegen die metallorganische Komponente inert sein soll. Der "bubbler" wird auf einer konstanten, relativ niedrigen Temperatur gehalten, die vorzugsweise über dem Schmelzpunkt der metallorganischen Verbindung, aber weit unterhalb der Zersetzungstemperatur liegt. Die Reaktions- oder Zersetzungskammer hat vorzugsweise eine sehr viel höhere Temperatur, die unterhalb 1100 °C liegt, bei welcher die metallorganische Verbindung sich vollständig zersetzt, und das Metall abgeschieden wird. Durch das Trägergas wird die metallorganische Verbindung in den Dampfzustand gebracht und mit dem Trägergas in die Zersetzungskammer geschleust. Der Massenfluß des Dampfes ist gut zu kontrollieren, und somit ist auch ein kontrolliertes Wachsen der dünnen Schichten möglich.

Bislang wurden für die Gasphasenabscheidung hauptsächlich Metallalkyle wie z.B. Trimethylgallium, Trimethylaluminium oder Trimethylindium verwendet. Diese Verbindungen sind jedoch extrem luftempfindlich, selbstentzündlich und teilweise bereits bei Raumtemperatur zersetzlich. Daher sind für die Herstellung, den Transport, die Lagerung und die Anwendung dieser Verbindungen aufwendige Vorsichtsmaßnahmen notwendig. Es sind auch einige, etwas stabilere Addukte der Metallalkyle mit Lewisbasen wie z.B. Trimethylamin und Triphenylphosphin bekannt (z.B. beschrieben in GB 21 23 422, EP-A 108469 oder EP-A 176537), die jedoch aufgrund des geringen Dampfdruckes nur bedingt für die Gasphasenabscheidung geeignet sind.

Ferner sind ähnliche Verbindungen in der DE-OS 36 31 469 beschrieben, die jedoch keine cyclischen Strukturen mit dem Metall im Cyclus aufweisen.

Aufgabe der vorliegenden Erfindung war es nun, Metallalkylverbindungen zu finden, die einfach handhabbar und bei Raumtemperatur stabil sind und die sich aus der Gasphase zersetzen lassen, also für die verschiedenen Methoden der Gasphasenabscheidung geeignet sind.

Überraschend wurde nun gefunden, daß sich bestimmte cyclische Verbindungen von Aluminium, Gallium und Indium durch eine hohe Stabilität gegenüber Luft und Sauerstoff auszeichnen, daher einfach zu handhaben sind und sich hervorragend für die Gasphasenabscheidung eignen.

Gegenstand der Erfindung sind somit die cyclischen metallorganischen Verbindungen der Formel I 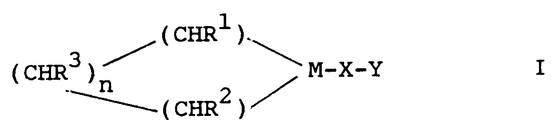
worin
- M: Aluminium, Gallium oder Indium,
- n: 1, 2, 3, 4, 5 oder 6,
- X: -(CHR⁴)ₘ- mit m = 1, 2, 3, 4 oder 5,
o-(CH₂)ₚ-C₆H₄-(CH₂)_{q}-,
o-(CH₂)ₚ-C₆H₁₀-(CH₂)_{q}-,
o-(CH₂)ₚ-C₆H₈-(CH₂)_{q}-,
o-(CH₂)ₚ-C₆H₆-(CH₂)_{q}-,
o-(CH₂)ₚ-C₅H₈-(CH₂)_{q}-,
o-(CH₂)ₚ-C₅H₆-(CH₂)_{q}-,
o-(CH₂)ₚ-C₅H₄-(CH₂)_{q}-,
o-(CH₂)ₚ-C₄H₆-(CH₂)_{q}-,
im Falle Y = -F, -CF₃, -C₂F₅, -C₃F₇ oder -C₄F₉ auch eine Einfachbindung,
- p und q: jeweils unabhängig voneinander 0, 1, 2 oder 3,
- R¹, R², R³ und R⁴: jeweils unabhängig voneinander H oder eine Alkylgruppe mit 1-4 C-Atomen,
- Y: -NR⁵R⁶, -PR⁵R⁶, -AsR⁵R⁶, -SbR⁵R⁶, -F, -CF₃, -C₂F₅, -C₃F₇ oder -C₄F₉,
und
- R⁵ und R⁶: jeweils unabhängig voneinander eine Alkylgruppe mit 1-8 C-Atomen, wobei die Alkylgruppe teilweise oder vollständig fluoriert sein kann, eine Cycloalkyl-, Alkenyl- oder Cycloalkenylgruppe mit jeweils 3-8 C-Atomen oder eine Phenylgruppe
bedeutet.

Ferner ist Gegenstand der Erfindung die Verwendung der Verbindungen der Formel I zur Gasphasenabscheidung sowie ein Verfahren zur Herstellung dünner Filme oder epitaktischer Schichten durch Gasphasenabscheidung des Metalls aus metallorganischen Verbindungen, bei welchem als metallorganische Substanzen die Verbindungen der Formel I eingesetzt werden.

Die Verbindungen der Formel I weisen eine cyclische Struktur auf und sind intramolekular stabilisiert durch Elektronenübertragung vom Stickstoff-, Phosphor-, Arsen-, Antimon- oder Fluoratom auf das elektronenarme III B-Element. Sie besitzen daher eine im Vergleich zu den bisher verwendeten Metallalkylen hohe Stabilität gegenüber Luft und Sauerstoff. Sie sind nicht mehr selbstentzündlich und damit einfach zu handhaben. In der Gasphase jedoch lassen sich die erfindungsgemäßen Verbindungen leicht unter Abscheidung des Metalls zersetzen.

In Formel I bedeutet M Aluminium (Al), Gallium (Ga) oder Indium (In), vorzugsweise Ga oder In.

Der Parameter n ist 1, 2, 3, 4, 5 oder 6, vorzugsweise 2, 3 oder 4. X bedeutet vorzugsweise -(CHR⁴)ₘ mit m = 1, 2, 3, 4 oder 5, vorzugsweise ist m 2, 3 oder 4.

R¹, R², R³ und R⁴ bedeuten unabhängig voneinander ein H-Atom oder eine Methyl-, Ethyl-, Propyl-, iso-Propyl-, Butyl-, sek.-Butyl- oder tert.-Butylgruppe. Vorzugsweise bedeuten R¹, R², R³ und R⁴ je ein H-Atom. Falls n bzw. m > 1 ist, so ist vorzugsweise höchstens ein Rest R³ oder R⁴ eine Alkylgruppe, die anderen Reste R³ bzw. R⁴ bedeuten dann H. Sind also mehrere Reste R³ oder R⁴ vorhanden, so können diese gleich oder verschieden sein.

Bevorzugt sind auch Verbindungen der Formel I, worin X
o-(CH₂)ₚ-C₆H₄-(CH₂)_{q}-, o-(CH₂)ₚ-C₆H₁₀-(CH₂)_{q}-,
o-(CH₂)ₚ-C₆H₈-(CH₂)_{q}-, o-(CH₂)ₚ-C₆H₆-(CH₂)_{q}-,
o-(CH₂)ₚ-C₅H₈-(CH₂)_{q}-, o-(CH₂)ₚ-C₅H₆-(CH₂)_{q}-,
o-(CH₂)ₚ-C₅H₄-(CH₂)_{q}-, o-(CH₂)ₚ-C₄H₆-(CH₂)_{q}-, bedeutet.

p und q bedeuten jeweils unabhängig voneinander 0, 1, 2 oder 3, vorzugsweise 1 oder 2. Dabei sind diejenigen Verbindungen bevorzugt, bei denen eine der Gruppen p und q 0 ist und die andere 1 oder 2 bedeutet.

Die folgenden Formeln (1) bis (16) sind bevorzugte Vertreter der Gruppierung -X-Y: 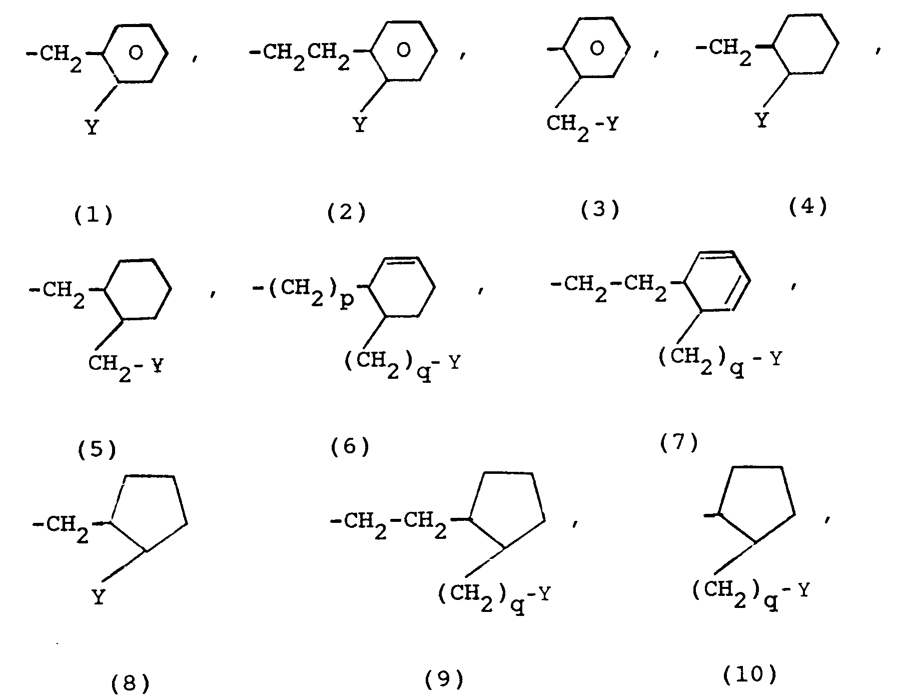 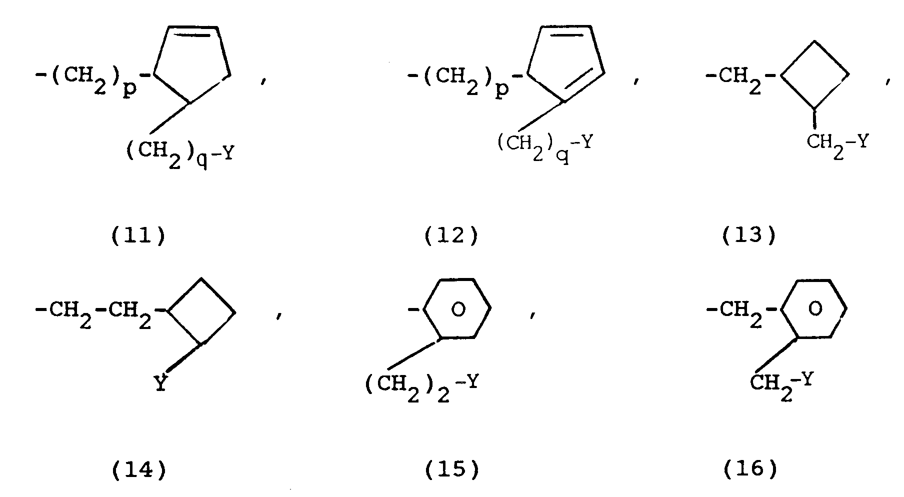
X kann eine Einfachbindung bedeuten, und zwar dann, wenn Y -F, -CF₃, -C₂F₅, -C₃F₇ oder -C₄F₉ darstellt.

Y in Formel I bedeutet vorzugsweise -NR⁵R⁶, -PR⁵R⁶ oder -AsR⁵R⁶, ferner -SbR⁵R⁶. Insbesondere bevorzugt ist -NR⁵R⁶.

Ferner sind Verbindungen der Formel I bevorzugt, in denen Y -F, -CF₃ oder -C₂F₅ darstellt.

Die Reste R⁵ und R⁶ in Formel I können jeweils eine geradkettige oder verzweigte Alkylgruppe mit 1-8 C-Atomen, vorzugsweise mit 1-4 C-Atomen bedeuten. Sie sind vorzugsweise geradkettig und bedeuten demnach bevorzugt Methyl, Ethyl, Propyl, Butyl, ferner auch Pentyl, Hexyl, Heptyl, Octyl, iso-Propyl, sek.-Butyl, tert.-Butyl, 2-Methylpentyl, 3-Methylpentyl oder 2-Octyl. Die Alkylreste können teilweise oder auch vollständig fluoriert sein und z.B. Monofluormethyl, Trifluormethyl, Difluorethyl, Trifluorethyl, Pentafluorethyl oder Trifluorpropyl bedeuten.

Falls R⁵ oder R⁶ eine Cycloalkyl- oder Cycloalkenylgruppe mit 3-8 C-Atomen bedeuten, so bedeuten sie vorzugsweise Cyclopropyl, Cyclobutyl, Cyclopentyl, Cyclopentenyl, Cyclohexyl, Cyclohexenyl, Cyclohexadienyl, Cycloheptyl, Cycloheptenyl, Cycloheptadienyl, Cyclooctyl, Cyclooctenyl, Cyclooctadienyl, Cyclooctatrienyl oder Cyclooctatetraenyl.

Vorzugsweise stellen R⁵ und/oder R⁶ auch Alkenylgruppen mit 3-8 C-Atomen, vorzugsweise mit 3-5 C-Atomen dar. Sie bedeuten demnach vorzugsweise Propenyl, Butenyl, Pentenyl, ferner Hexenyl, Heptenyl oder Octenyl.

Weiterhin sind Verbindungen der Formel I bevorzugt, worin R⁵ und/oder R⁶ eine Phenylgruppe bedeuten. Diese Phenylgruppe kann auch substituiert vorliegen. Da diese Substituenten keinen wesentlichen Einfluß auf den angestrebten Verwendungszweck ausüben, sind alle Substituenten erlaubt, die keinen störenden Einfluß auf die Zersetzungsreaktion haben.

Folgende Verbindungen stellen eine kleinere Gruppe von besonders bevorzugten Verbindungen der Formel I dar:
1-Galla-1-(3-dimethylaminopropyl)-cyclopentan
1-Galla-1-(2-dimethylaminoethyl)-cyclopentan
1-Inda-1-(3-diethylaminopropyl)-cyclopentan
1-Alumina-1-(3-dimethylaminopropyl)-cyclopentan
1-Galla-1-(3-dimethylaminopropyl)-cyclobutan
1-Inda-1-(2-diethylaminoethyl)-cyclobutan
1-Alumina-1-(4-dimethylaminobutyl)-cyclobutan
1-Galla-1-(o-dimethylaminobenzyl)-cyclohexan
1-Galla-1-(o-dimethylaminobenzyl)-cyclobutan
1-Alumina-1-(o-diethylaminobenzyl)-cyclopentan
1-Alumina-1-(o-diethylaminobenzyl)-cyclohexan
1-Inda-1-(o-diisopropylaminobenzyl)-cyclobutan
1-Inda-1-(o-dimethylaminobenzyl)-cyclopentan
1-Inda-1-(o-dimethylaminobenzyl)-cyclohexan
1-Galla-1-(o-dimethylaminobenzyl)-cyclopentan
1-Galla-1-(o-diethylaminobenzyl)-cyclohexan
1-Galla-1-(o-dipropylaminobenzyl)-cycloheptan
1-Inda-1-(o-dibutylaminobenzyl)-cyclopentan
1-Inda-1-(o-diethylaminobenzyl)-cyclohexan
1-Inda-1-(o-dimethylaminobenzyl)-cyclooctan
1-Alumina-1-(o-di-isopropylaminobenzyl)-cyclohexan
1-Alumina-1-(2-o-dimethylaminophenylethyl)-cyclopentan
1-Alumina-1-(2-o-diethylaminophenylethyl)-cyclobutan
1-Galla-1-(X-PR⁵R⁶)-cyclopentan
1-Galla-1-(X-PR⁵R⁶)-cyclobutan
1-Galla-1-(X-PR⁵R⁶)-cyclohexan
1-Alumina-1-(X-PR⁵R⁶)-cyclopentan
1-Alumina-1-(X-PR⁵R⁶)-cyclohexan
1-Inda-1-(X-PR⁵R⁶)-cyclopentan
1-Inda-1-(X-AsR⁵R⁶)-cyclohexan
1-Inda-1-(X-AsR⁵R⁶)-cyclopentan
1-Inda-1-(X-SbR⁵R⁶)-cyclopentan
1-Alumina-1-(X-AsR⁵R⁶)-cycloheptan
1-Galla-1-(X-SbR⁵R⁶)-cyclooctan
1-Galla-1-(X-CF₃)-cyclobutan
1-Galla-1-(X-F)-cyclopentan
1-Galla-1-trifluormethyl-cyclopentan
1-Galla-1-trifluormethyl-cyclohexan
1-Inda-1-trifluormethyl-cyclohexan
1-Inda-1-fluor-cyclopentan
1-Alumina-1-pentafluorethyl-cyclohexan
1-Galla-1-pentafluorethyl-cyclopentan
1-Galla-1-fluor-cycloheptan
1-Alumina-1-fluor-cyclohexan
1-Galla-1-heptafluorpropyl-cyclopentan
1-Galla-1-(X-C₂F₅)-cyclopentan
1-Inda-1-(X-C₃F₇)-cyclohexan
1-Galla-1-(X-C₄F₉)-cyclopentan.

Die Verbindungen der Formel I sind hervorragend für die MOCVD-Epitaxie bzw. MOCVD-Methode geeignet, da sie sich bei höheren Temperaturen unter Freisetzung des entsprechenden Metalles zersetzen. Sie sind ebenfalls für die anderen Methoden der Gasphasenabscheidung wie Photo-MOVP, Laser CVD oder MOMS geeignet.

Die Verbindungen der Formel I werden nach an sich bekannten Methoden hergestellt, wie sie in der Literatur (z.B. G. Bähr, P. Burba, Methoden der Organischen Chemie, Bd. XIII/4, Georg Thieme Verlag, Stuttgart (1970)) beschrieben sind, und zwar unter Reaktionsbedingungen, die für die genannten Umsetzungen bekannt und geeignet sind. Dabei kann man auch von an sich bekannten, hier nicht erwähnten Varianten Gebrauch machen.

So können Verbindungen der Formel I z.B. hergestellt werden, indem man Metallalkylchloride mit einem Alkalimetallorganyl der entsprechenden Lewisbase oder einer Grignard-Verbindung in einem inerten Lösungsmittel umsetzt.

Die Umsetzungen erfolgen vorzugsweise in inerten Lösungsmitteln. Als Lösungsmittel kommen dabei alle diejenigen in Frage, die die Umsetzung nicht stören und nicht in das Reaktionsgeschehen eingreifen. Die Reaktionstemperaturen entsprechen im wesentlichen denen, die aus der Literatur für die Herstellung ähnlicher Verbindungen bekannt sind.

Beim erfindungsgemäßen Verfahren zur Herstellung dünner Filme oder epitaktischer Schichten auf beliebigen Substraten setzt man bei den an sich bekannten Gasphasenabscheidungs-Prozessen von metallorganischen Verbindungen als Ausgangsverbindungen die intramolekular stabilisierten, metallorganischen Verbindungen der Formel I ein.

Zur Herstellung von Verbindungshalbleitern werden beim erfindungsgemäßen Verfahren während des Abscheidungsprozesses in der Zersetzungskammer eine oder mehrere unter den angewandten Reaktionsbedingungen gasförmige Verbindungen des Arsens, Antimons oder Phosphors, beispielsweise AsH₃, As(CH₃)₃, PH₃ oder SbH₃, zugesetzt.

Eine weitere Variante des erfindungsgemäßen Verfahrens besteht darin, daß man während des Abscheidungsprozesses zusätzlich zu den erfindungsgemäßen metallorganischen Verbindungen der Formel I Dotierstoffe zusetzt. Als Dotierstoffe werden dabei flüchtige metallorganische Verbindungen von Eisen, Magnesium, Zink oder Chrom eingesetzt. Als bevorzugte Verbindungen gelten dabei z. B. Zn(CH₃)₂, Mg(CH₃)₂ oder Fe(C₅H₅)₂.

Die nach den erfindungsgemäßen Verfahren hergestellten Schichten können verwendet werden für die Herstellung von elektronischen und optoelektronischen Schaltelementen, Verbindungshalbleitern oder Lasern.

Da bei den momentan im Einsatz befindlichen Epitaxieanlagen aus thermodynamischen Gründen nur ca. 1-10 % der eingesetzten freien Metallalkyle als Epitaxieschicht auf dem Substrat abgeschieden werden kann, stellt die Vernichtung der überschüssigen Metallalkyle, die aufgrund ihrer extremen Empfindlichkeit nicht zurückgewonnen werden können, ein erhebliches Problem dar.

Die erfindungsgemäßen Verbindungen der Formel I eröffnen dagegen aufgrund ihrer hohen Stabilität neue Möglichkeiten zur gefahrlosen Vernichtung oder zur Rückgewinnung der wertvollen III B-Verbindungen.

Die folgenden Beispiele sollen die Erfindung näher erläutern. Temperaturangaben erfolgen in Grad Celsius oder Kelvin. Fp. bedeutet Schmelzpunkt und Kp. Siedepunkt.

### Beispiel 1

0,64 mol Magnesiumspäne, durch Iod aktiviert, werden in 200 ml Diethylether vorgelegt. Nach Zugabe von 0,16 mol 1,4-Dichlorbutan erwärmt man 3 Stunden unter Rückfluß.

Zu dieser Grignardlösung gibt man bei 0° 0,15 mol 3-Dimethylaminopropyl-galliumdichlorid in 250 ml Diethylether. Man rührt die Reaktionsmischung noch eine Stunde bei Raumtemperatur, destilliert die flüchtigen Bestandteile bei einer Badtemperatur bis zu 200° und einem Druck von 10⁻² mbar ab und erhält durch fraktionierte Destillation des Destillats 1-Galla-1-(3-dimethylaminopropyl)-cyclopentan als klare, luftstabile Flüssigkeit.
- Massenspektrum: m/e (I_{rel.}) =: 225 (35; M⁺)
182 (52; M⁺, -C₃H₇)
155 (40; M⁺, -C₅H₁₀)
86 (53; (CH₃)₂-N-(CH₂)₃⁺)
58 (100; (CH₃)₂NCH₂⁺).

Analog werden hergestellt:
1-Galla-1-(2-dimethylaminoethyl)-cyclopentan
1-Galla-1-(2-diethylaminoethyl)-cyclopentan
1-Galla-1-(2-dipropylaminoethyl)-cyclopentan
1-Galla-1-(2-di-isopropylaminoethyl)-cyclopentan
1-Galla-1-(2-dibutylaminoethyl)-cyclopentan
1-Galla-1-(3-diethylaminopropyl)-cyclopentan
1-Galla-1-(3-dipropylaminopropyl)-cyclopentan
1-Galla-1-(3-di-isopropylaminopropyl)-cyclopentan
1-Galla-1-(3-dibutylaminopropyl)-cyclopentan
1-Galla-1-(4-dimethylaminobutyl)-cyclopentan
1-Galla-1-(4-diethylaminobutyl)-cyclopentan
1-Galla-1-(4-dipropylaminobutyl)-cyclopentan
1-Galla-1-(4-di-isopropylaminobutyl)-cyclopentan
1-Galla-1-(4-dibutylaminobutyl)-cyclopentan
1-Alumina-1-(3-dimethylaminopropyl)-cyclopentan
1-Alumina-1-(3-diethylaminopropyl)-cyclopentan
1-Alumina-1-(3-dipropylaminopropyl)-cyclopentan
1-Alumina-1-(3-di-isopropylaminopropyl)-cyclopentan
1-Alumina-1-(3-dibutylaminopropyl)-cyclopentan
1-Alumina-1-(2-dimethylaminoethyl)-cyclopentan
1-Alumina-1-(2-diethylaminoethyl)-cyclopentan
1-Alumina-1-(2-dipropylaminoethyl)-cyclopentan
1-Alumina-1-(2-di-isopropylaminoethyl)-cyclopentan
1-Alumina-1-(2-dibutylaminoethyl)-cyclopentan
1-Alumina-1-(4-dimethylaminobutyl)-cyclopentan
1-Alumina-1-(4-diethylaminobutyl)-cyclopentan
1-Alumina-1-(4-dipropylaminobutyl)-cyclopentan
1-Alumina-1-(4-di-isopropylaminobutyl)-cyclopentan
1-Alumina-1-(4-dibutylaminobutyl)-cyclopentan
1-Inda-1-(3-dimethylaminopropyl)-cyclopentan
1-Inda-1-(3-diethylaminopropyl)-cyclopentan
1-Inda-1-(3-dipropylaminopropyl)-cyclopentan
1-Inda-1-(3-di-isopropylaminopropyl)-cyclopentan
1-Inda-1-(3-dibutylaminopropyl)-cyclopentan
1-Inda-1-(2-dimethylaminoethyl)-cyclopentan
1-Inda-1-(2-diethylaminoethyl)-cyclopentan
1-Inda-1-(2-dipropylaminoethyl)-cyclopentan
1-Inda-1-(2-di-isopropylaminoethyl)-cyclopentan
1-Inda-1-(2-dibutylaminoethyl)-cyclopentan
1-Inda-1-(4-dimethylaminobutyl)-cyclopentan
1-Inda-1-(4-diethylaminobutyl)-cyclopentan
1-Inda-1-(4-dipropylaminobutyl)-cyclopentan
1-Inda-1-(4-di-isopropylaminobutyl)-cyclopentan
1-Inda-1-(4-dibutylaminobutyl)-cyclopentan.

### Beispiel 2

0,25 mol Magnesiumspäne, durch Iod aktiviert, werden in 100 ml Diethylether vorgelegt. Nach Zugabe von 0,06 mol 1,5-Dichlorpentan bei Raumtemperatur wird 3 Stunden unter Rückfluß erwärmt.

Die vom Magnesium abdekantierte Grignardlösung und 0,06 mol 3-Dimethylaminopropylgalliumdichlorid, in 150 ml Ether gelöst, werden synchron unter kräftigem Rühren zur Reaktion zusammengeführt.

Anschließend wird das Reaktionsgemisch bei Raumtemperatur gerührt. Die flüchtigen Bestandteile werden bei einer Badtemperatur bis zu 180° und einem Druck von 10⁻² mbar abdestilliert und nochmals fraktioniert destilliert.

Man erhält 1-Galla-1-(3-dimethylaminopropyl)-cyclohexan als wasserklare, luftstabile Flüssigkeit.
- Massenspektrum: m/e (I_{rel.}) =: 211 (17; M⁺)
155 (40; M⁺, -C₄H₈)
86 (66; (CH₃)₂N-(CH₂)₃⁺)
58 (100; (CH₃)₂N-CH₂⁺).

Analog werden hergestellt:
1-Galla-1-(3-diethylaminopropyl)-cyclohexan
1-Galla-1-(3-dipropylaminopropyl)-cyclohexan
1-Galla-1-(3-di-isopropylaminopropyl)-cyclohexan
1-Galla-1-(3-dibutylaminopropyl)-cyclohexan
1-Galla-1-(2-dimethylaminoethyl)-cyclohexan
1-Galla-1-(2-diethylaminoethyl)-cyclohexan
1-Galla-1-(2-dipropylaminoethyl)-cyclohexan
1-Galla-1-(2-di-isopropylaminoethyl)-cyclohexan
1-Galla-1-(2-dibutylaminoethyl)-cyclohexan
1-Galla-1-(4-dimethylaminobutyl)-cyclohexan
1-Galla-1-(4-diethylaminobutyl)-cyclohexan
1-Galla-1-(4-dipropylaminobutyl)-cyclohexan
1-Galla-1-(4-di-isopropylaminobutyl)-cyclohexan
1-Galla-1-(4-dibutylaminobutyl)-cyclohexan
1-Alumina-1-(3-dimethylaminopropyl)-cyclohexan
1-Alumina-1-(3-diethylaminopropyl)-cyclohexan
1-Alumina-1-(3-dipropylaminopropyl)-cyclohexan
1-Alumina-1-(3-di-isopropylaminopropyl)-cyclohexan
1-Alumina-1-(3-dibutylaminopropyl)-cyclohexan
1-Alumina-1-(2-dimethylaminoethyl)-cyclohexan
1-Alumina-1-(2-diethylaminoethyl)-cyclohexan
1-Alumina-1-(2-dipropylaminoethyl)-cyclohexan
1-Alumina-1-(2-di-isopropylaminoethyl)-cyclohexan
1-Alumina-1-(2-dibutylaminoethyl)-cyclohexan
1-Alumina-1-(4-dimethylaminobutyl)-cyclohexan
1-Alumina-1-(4-diethylaminobutyl)-cyclohexan
1-Alumina-1-(4-dipropylaminobutyl)-cyclohexan
1-Alumina-1-(4-di-isopropylaminobutyl)-cyclohexan
1-Alumina-1-(4-dibutylaminobutyl)-cyclohexan
1-Inda-1-(3-dimethylaminopropyl)-cyclohexan
1-Inda-1-(3-diethylaminopropyl)-cyclohexan
1-Inda-1-(3-dipropylaminopropyl)-cyclohexan
1-Inda-1-(3-di-isopropylaminopropyl)-cyclohexan
1-Inda-1-(3-dibutylaminopropyl)-cyclohexan
1-Inda-1-(2-dimethylaminoethyl)-cyclohexan
1-Inda-1-(2-diethylaminoethyl)-cyclohexan
1-Inda-1-(2-dipropylaminoethyl)-cyclohexan
1-Inda-1-(2-di-isopropylaminoethyl)-cyclohexan
1-Inda-1-(2-dibutylaminoethyl)-cyclohexan
1-Inda-1-(4-dimethylaminobutyl)-cyclohexan
1-Inda-1-(4-diethylaminobutyl)-cyclohexan
1-Inda-1-(4-dipropylaminobutyl)-cyclohexan
1-Inda-1-(4-di-isopropylaminobutyl)-cyclohexan
1-Inda-1-(4-dibutylaminobutyl)-cyclohexan.

### Beispiel zur Herstellung dünner Filme

### Beispiel A:

1-Galla-1-(3-dimethylaminopropyl)-cyclohexan (dargestellt nach Beispiel 2) wird in den "bubbler" gefüllt und mit der Gaszufuhr des inerten Gases und der Zersetzungskammer verbunden. Abhängig vom Partialdampfdruck des Reagenzes im Reaktor erfolgt eine Zersetzung unter Galliumabscheidung bei Temperaturen von ca. 700°.

### Beispiel B

(3-Dimethylaminopropyl)-1-galla-cyclohexan und AsH₃ wurden in einer Niederdruck-MOCVD-Anlage (1000 - 2000 Pa) epitaxiert. Die Wachstumstemperaturen lagen zwischen 850 K und 1050 K. Die Elektronenbeweglichkeit der epitaxierten GaAs-Schicht bei 77 K betrug µ₇₇ = 51000 cm²/Vs mit einer Ladungsträger-Konzentration von n₇₇ = 8 x 10¹⁴ cm⁻³. Ein Stickstoffeinbau wurde nicht beobachtet.

### Beispiel C

(3-Dimethylaminopropyl)-1-alumina-cyclohexan, Et₃Ga und AsH₃ wurden in einer Niederdruck-MOCVD-Anlage (1000 - 2000 Pa) epitaxiert. Die Wachstumstemperaturen lagen zwischen 850 K und 1050 K. Die Elektronenbeweglichkeit der epitaxierten AlGaAs-Schicht bei 77 K betrug µ₇₇ = 6900 cm²/Vs. Ein Stickstoffeinbau wurde nicht beobachtet.

## Patentansprüche

1. Cyclische metallorganische Verbindungen der Formel I 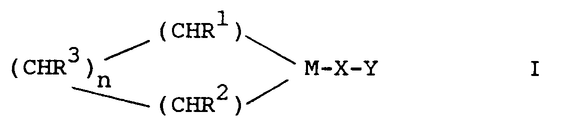 worin
M Aluminium, Gallium oder Indium,
n 1, 2, 3, 4, 5 oder 6,
X -(CHR⁴)ₘ- mit m = 1, 2, 3, 4 oder 5,
o-(CH₂)ₚ-C₆H₄-(CH₂)_{q}-,
o-(CH₂)ₚ-C₆H₁₀-(CH₂)_{q}-,
o-(CH₂)ₚ-C₆H₈-(CH₂)_{q}-,
o-(CH₂)ₚ-C₆H₆-(CH₂)_{q}-,
o-(CH₂)ₚ-C₅H₈-(CH₂)_{q}-,
o-(CH₂)ₚ-C₅H₆-(CH₂)_{q}-,
o-(CH₂)ₚ-C₅H₄-(CH₂)_{q}-,
o-(CH₂)ₚ-C₄H₆-(CH₂)_{q}-,
im Falle Y = -F, -CF₃, -C₂F₅, -C₃F₇ oder -C₄F₉ auch eine Einfachbindung,
p und q jeweils unabhängig voneinander 0, 1, 2 oder 3,
R¹, R², R³ und R⁴ jeweils unabhängig voneinander H oder eine Alkylgruppe mit 1-4 C-Atomen,
Y -NR⁵R⁶, -PR⁵R⁶, -AsR⁵R⁶, -SbR⁵R⁶, -F, -CF₃, -C₂F₅, -C₃F₇ oder -C₄F₉,
und
R⁵ und R⁶ jeweils unabhängig voneinander eine Alkylgruppe mit 1-8 C-Atomen, wobei die Alkylgruppe teilweise oder vollständig fluoriert sein kann, eine Cycloalkyl-, Alkenyl- oder Cycloalkenylgruppe mit jeweils 3-8 C-Atomen oder eine Phenylgruppe
bedeutet.

2. Verwendung der cyclischen metallorganischen Verbindungen der Formel I nach Anspruch 1 zur Gasphasenabscheidung des Metalls auf Substraten.

3. Verwendung der cyclischen metallorganischen Verbindungen der Formel I nach Anspruch 1 zur Abscheidung epitaktischer Schichten.

4. Verfahren zur Herstellung dünner Filme auf Substraten durch Gasphasenabscheidung des Metalls aus metallorganischen Verbindungen, dadurch gekennzeichnet, daß als metallorganische Verbindungen solche der Formel I nach Anspruch 1 eingesetzt werden.

5. Verfahren nach Anspruch 4, dadurch gekennzeichnet, daß man zur Herstellung von Verbindungshalbleitern während des Abscheidungsprozesses eine oder mehrere unter den angewandten Reaktionsbedingungen gasförmige Verbindungen des Arsens, Antimons oder Phosphors zuführt.

6. Verfahren nach Anspruch 4, dadurch gekennzeichnet, daß man zusätzlich zu den metallorganischen Verbindungen der Formel I während des Abscheidungsprozesses Dotierstoffe zusetzt.

## Claims

1. Cyclic organometallic compounds of the formula I 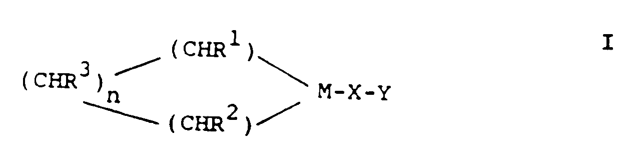 wherein
M is aluminium, gallium or indium,
n is 1, 2, 3, 4, 5 or 6,
X is -(CHR⁴)ₘ- where m = 1, 2, 3, 4 or 5,
o-(CH₂)ₚ-C₆H₄-(CH₂)_{q}-,
o-(CH₂)ₚ-C₆H₁₀-(CH₂)_{q}-,
o-(CH₂)ₚ-C₆H₈-(CH₂)_{q}-,
o-(CH₂)ₚ-C₆H₆-(CH₂)_{q}-,
o-(CH₂)ₚ-C₅H₈-(CH₂)_{q}-,
o-(CH₂)ₚ-C₅H₆-(CH₂)_{q}-,
o-(CH₂)ₚ-C₅H₄-(CH₂)_{q}-,
o-(CH₂)ₚ-C₄H₆-(CH₂)_{q}-,
if Y = -F, -CF₃, -C₂F₅, -C₃F₇ or -C₄F₉, also a single bond,
p and q are, in each case independently of each other, 0, 1, 2 or 3,
R¹, R², R³ and R⁴ are, in each case independently of each other, H or an alkyl group containing 1-4 carbon atoms,
Y is -NR⁵R⁶, -PR⁵R⁶, -AsR⁵R⁶, -SbR⁵R⁶, -F, -CF₃, -C₂F₅, -C₃F₇ or -C₄F₉,
and
R⁵ and R⁶ are, in each case independently of each other, an alkyl group containing 1-8 carbon atoms, it being possible for the alkyl group to be partially or completely fluorinated, a cycloalkyl group, alkenyl group or cycloalkenyl group containing, in each case, 3-8 carbon atoms, or a phenyl group.

2. Use of the cyclic organometallic compounds of the formula I according to Claim 1 for the gas-phase deposition of metals on substrates.

3. Use of cyclic organometallic compounds of the formula I according to Claim 1 for the deposition of epitaxial layers.

4. Process for producing thin films on substrates by gas-phase deposition of the metal from organometallic compounds, characterized in that the organometallic compounds used are compounds of the formula I according to Claim 1.

5. Process according to Claim 4, characterized in that, to produce compound semiconductors, one or more compounds of arsenic, antimony or phosphorus which are gaseous under the reaction conditions used are fed in during the deposition process.

6. Process according to Claim 4, characterized in that dopants are added during the deposition process in addition to the organometallic compounds of the formula I.

## Revendications

1. Composés organométalliques cycliques de formule I 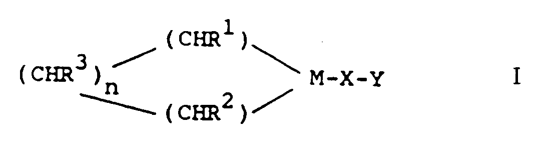 dans laquelle
M représente l'aluminium, le gallium ou l'indium,
n est égal à 1, 2, 3, 4, 5 ou 6,
X représente
(CHR⁴)ₘ- avec m = 1, 2, 3, 4 ou 5,
o-(CH₂)ₚ-C₆H₄-(CH₂)_{q}-,
o-(CH₂)ₚ-C₆H₁₀-(CH₂)_{q}-,
o-(CH₂)ₚ-C₆H₈-(CH₂)_{q}-,
o-(CH₂)ₚ-C₆H₆-(CH₂)_{q}-,
o-(CH₂)ₚ-C₅H₈-(CH₂)_{q}-,
o-(CH₂)ₚ-C₅H₆-(CH₂)_{q}-,
o-(CH₂)ₚ-C₅H₄-(CH₂)_{q}-,
o-(CH₂)ₚ-C₄H₆-(CH₂)_{q}-,
ou encore une liaison simple lorsque Y = -F, -CF₃, -C₂F₅, -C₂F₇ ou -C₄F₉,
p et q sont égaux chacun, indépendamment l'un de l'autre, à 0, 1, 2 ou 3,
R¹, R², R³ et R⁴ représentent chacun, indépendamment les uns des autres, H ou un groupe alkyle en C1-C4,
Y représente
-NR⁵R⁶, -PR⁵R⁶, -AsR⁵R⁶, -SbR⁵R⁶, -F, -CF₃, -C₂F₅, -C₃F₇ oder -C₄F₉,
et
R⁵ et R⁶ représentent chacun, indépendamment l'un de l'autre, un groupe alkyle en C1-C8 qui peut être fluoré ou en totalité ou en partie, un groupe cycloalkyle, alcényle ou cycloalcényle contenant chacun 3 à 8 atomes de carbone, ou un groupe phényle.

2. Utilisation des composés organométalliques cycliques de formule I selon la revendication 1 pour la déposition en phase gazeuse du métal sur des supports.

3. Utilisation des compoés organométalliques cycliques de formule I selon revendication 1 pour la déposition de couches épitactiques.

4. Procédé pour l'application de pellicules minces sur des supports par déposition en phase gazeuse du métal de composés organométalliques, caractérisé en ce que l'on utilise en tant que composés organométalliques les composés de formule I de la revendication 1.

5. Procédé selon revendication 4, caractérisé en ce que, pour la fabrication de semi-conducteurs composites, on introduit durant l'opération de déposition un ou plusieurs composés de l'arsenic, de l'antimoine ou du phosphore, gazeux dans les conditions de réaction observées.

6. Procédé selon revendication 4, caractérisé en ce que, durant l'opération de déposition et en plus des composés organométalliques de formule I, on ajoute des agents dopants.
